# EUROPÄISCHE PATENTANMELDUNG

(11) **EP 2 696 504 A1**
(43) Veröffentlichungstag der Anmeldung: **12.02.2014**
(21) Anmeldenummer: 13179003.2
(22) Anmeldetag: 01.08.2013
(51) Int. Cl.: H03K 17/96

(54) **Gehäuseteil für eine Bedieneinrichtung, Bedieneinrichtung und Elektrogerät**

(30) Priorität: 09.08.2012 DE 102012214218
(71) Anmelder: E.G.O. Elektro-Gerätebau GmbH, 75038 Oberderdingen (DE)
(72) Erfinder: Graff, Frank, 72379 Radensleben (DE); Kuehn, Henry, 16540 Hohen Neuendorf (DE); Ungethuem, Uwe, 15528 Spreenhagen (DE); Dieringer, Achim, 72379 Hechingen (DE); Trumpa, Klaus, 72336 Balingen (DE)
(74) Vertreter: Patentanwälte Ruff, Wilhelm, Beier, Dauster & Partner

(57) **Zusammenfassung**

Eine Bedieneinrichtung (11) für einen Geschirrspüler als Elektrogerät weist Bedienelemente als kapazitive Berührungssensoren mit Sensorelementkörpern (22), einen Bauteilträger (17) mit Schaltungsbauteilen (26) und Leuchtmitteln (25), Lichtleitermittel (19) für die Leuchtmittel und ein Gehäuse (13, 15) für den Bauteilträger auf, welches den Bauteilträger umschließt. Das Gehäuse weist zwei Gehäuseteile auf, wobei ein erstes Gehäuseteil (13) aus lichtundurchlässigem Material besteht und ein zweites Gehäuseteil (15) zumindest teilweise lichtleitend ist. Die Lichtleitermittel sind in das zweite Gehäuseteil integriert und auch die Sensorelementkörper sind in dem zweiten Gehäuseteil angeordnet, insbesondere sind diese durch ein Mehrkomponenten-Spritzgussverfahren eingespritzt.

## Beschreibung

Die Erfindung betrifft ein Gehäuseteil für eine Bedieneinrichtung, eine Bedieneinrichtung für ein Elektrogerät sowie ein Elektrogerät mit einer solchen Bedieneinrichtung.

Gehäuseteile für Bedieneinrichtungen sind aus dem Stand der Technik bekannt. Bei Bedieneinrichtungen werden häufig für sogenannte Berührungsschalter elektrisch leitfähige und elastische Sensorelementkörper verwendet, um damit Berührungsschalter aufzubauen, siehe hierzu beispielsweise die EP 859467 A1.

Des Weiteren sind Bedieneinrichtungen mit solchen Berührungsschaltern und Leuchtmitteln samt Lichtleitermitteln bekannt, die in verschiedene Elektrogeräte, beispielsweise ein Kochfeld odgl., eingebaut werden können.

### Aufgabe und Lösung

Der Erfindung liegt die Aufgabe zugrunde, ein eingangs genanntes Gehäuseteil, eine Bedieneinrichtung für ein Elektrogerät sowie ein Elektrogerät mit einer solchen Bedieneinrichtung zu schaffen, mit denen Probleme des Standes der Technik gelöst werden können und es insbesondere möglich ist, effiziente Fertigungsmethoden zu verwenden und eine montage- und bedienungsfreundliche Bedieneinrichtung zu schaffen.

Gelöst wird diese Aufgabe durch ein Gehäuseteil mit den Merkmalen des Anspruchs 1, eine Bedieneinrichtung mit den Merkmalen des Anspruchs 3 sowie ein Elektrogerät mit den Merkmalen des Anspruchs 12. Vorteilhafte sowie bevorzugte Ausgestaltungen der Erfindung sind Gegenstand der weiteren Ansprüche und werden im Folgenden näher erläutert. Dabei werden manche der im Folgenden genannten Merkmale nur für das Gehäuseteil, die Bedieneinrichtung oder das Elektrogerät genannt bzw. erläutert. Sie sollen jedoch unabhängig davon sowohl für das Gehäuseteil als auch die Bedieneinrichtung und das Elektrogerät selbstständig gelten können. Der Wortlaut der Ansprüche wird durch ausdrückliche Bezugnahme zum Inhalt der Beschreibung gemacht.

Es ist vorgesehen, dass das Gehäuseteil mehrere Abschnitte aufweist, insbesondere Lichtleiterabschnitte, welche auch als Lichtleitermittel angesehen werden können. Diese Abschnitte oder Lichtleiterabschnitte bzw. Lichtleitermittel verlaufen vorteilhaft mit gleicher bzw. paralleler Erstreckungsrichtung. Das Gehäuseteil mit seinen Abschnitten bzw. die Lichtleiterabschnitte sind zusammenhängend ausgebildet. An dem Gehäuseteil ist erfindungsgemäß eine Vielzahl von genannten elektrisch leitfähigen und elastischen bzw. raumformveränderlichen Sensorelementkörpern angeordnet, wobei diese zusammen mit dem Gehäuseteil hergestellt sind. Hierfür bietet sich insbesondere ein Mehrkomponenten-Spritzgußverfahren an für das Gehäuseteil und vorteilhaft auch für eine gemeinsame Herstellung.

Derartige elastische Sensorelementkörper können aus elastischem Material gemäß dem Stand der Technik bestehen. Für die Abschnitte des Gehäuseteils eignen sich im Fall der Ausbildung als Lichtleiterabschnitte bzw. Lichtleitermittel Kunststoffe wie Polycarbonat, Polymethylmethacrylat oder ABS. Vorteilhaft ist dabei das Gehäuseteil mit den einzelnen Abschnitten bzw. Lichtleiterabschnitten einstückig hergestellt.

Eine Bedieneinrichtung für ein Elektrogerät weist kapazitive Berührungssensoren als Bedienelemente auf, einen Bauteilträger mit Schaltungsbauteilen und Leuchtmitteln sowie ein Gehäuse für den Bauteilträger. Des Weiteren sind Lichtleitermittel oder vorgenannte Lichtleiterabschnitte für die Leuchtmittel vorgesehen und Sensorelementkörper, die kapazitive Sensorelemente bilden für die genannten Bedienelemente. Das Gehäuse kann dabei den Bauteilträger aufnehmen bzw. zumindest teilweise umschließen. Vorteilhaft umschließt das Gehäuse den Bauteilträger im Wesentlichen vollständig, insbesondere lichtundurchlässig und/oder staubundurchlässig, wobei Licht hauptsächlich an den Lichtleitermitteln austreten soll.

Erfindungsgemäß ist vorgesehen, dass das Gehäuse mindestens zwei Gehäuseteile aufweist. Ein erstes Gehäuseteil besteht aus lichtundurchlässigem Material, insbesondere Kunststoff, wobei hier ein sehr einfacher bzw. günstiger und leicht herstellbarer Kunststoff verwendet werden kann, beispielsweise auch recycelter Kunststoff. Ein zweites Gehäuseteil ist zumindest teilweise lichtleitend bzw. lichtdurchlässig oder transparent. Vorteilhaft besteht das gesamte zweite Gehäuseteil aus lichtleitendem bzw. transparentem Kunststoff. Je nach Verwendungszweck kann es durch eine Beschichtung, Beklebung oder Lackierung in manchen Bereichen lichtundurchlässig abgedeckt sein. Die Lichtleitermittel entsprechen den vorgenannten Lichtleiterabschnitten und sind in das zweite Gehäuseteil integriert, so dass dieses zweite Gehäuseteil auch als eingangs beschriebenes Gehäuseteil ausgebildet sein kann. Auch die Sensorelementkörper für die Bedienelemente sind in dem zweiten Gehäuseteil angeordnet, wobei sie vorteilhaft gemäß dem vorbeschriebenen Aspekt integriert bzw. eingespritzt sein können. Somit kann ein mehrteiliges bzw. zweiteiliges Gehäuse für einen Bauteilträger einer Bedieneinrichtung geschaffen werden, welches Sensorelementkörper für kapazitive Sensorelemente einerseits und Lichtleitermittel für Leuchtanzeigen andererseits bereits aufweist. Wie nachfolgend noch näher erläutert wird, kann ein Bauteilträger in dieses Gehäuse eingesetzt werden und weist zwar Leuchtmittel auf. Die genannten Lichtleitermittel und Sensorelementkörper für die Sensorelemente sind jedoch bereits im Gehäuse vorhanden, so dass keine dafür notwendigen zusätzlichen Montageschritte anfallen.

Vorteilhaft sind die Gehäuseteile schalenartig ausgebildet, insbesondere für eine zuverlässige Aufnahme des Bauteilträgers als auch eine Abdichtung gegen schädliche Umwelteinflüsse. Das Gehäuse kann dabei in zwei etwa gleich große Halbschalen als Gehäuseteile unterteilt sein, alternativ auch in unterschiedlich große Schalen.

Besonders vorteilhaft besteht das gesamte zweite Gehäuseteil im Wesentlichen aus transparentem bzw. lichtleitendem Kunststoff. Die Lichtleitermittel bzw. Lichtleiterabschnitte sind daran integral ausgebildet in Form von zumindest teilweise in mindestens eine Richtung abstehender und voneinander durch einen Luftspalt getrennter Vorsprünge. Diese Vorsprünge können an einem Ende zu dem Bauteilträger bzw. zu auf dem Bauteilträger angeordneten Leuchtmitteln, insbesondere LED, hinweisen zur Lichteinkopplung. Am anderen Ende können die Lichtleitermittel ebenfalls nach Art von Vorsprüngen etwas abstehen und Flächen zum Auskoppeln des Lichts bzw. Abstrahlflächen bilden. Die Ausbildung der Lichtleitermittel bzw. Lichtleiterabschnitte als Vorsprünge weist den Vorteil auf, dass dadurch ein Überstrahlen untereinander stark reduziert werden kann. Des Weiteren können Einschnitte zwischen den einzelnen Lichtleiterabschnitten zumindest an deren Ende vorgesehen sein.

Es ist möglich, die Lichtleitermittel gebogen auszubilden. Eine im Wesentlichen gleichmäßige Biegung beeinträchtigt die Funktion der Lichtleitung nicht. Eine Biegung kann mindestens einen Viertelkreis einnehmen bzw. beschreiben, unter Umständen auch etwas mehr. Dadurch ist es nicht nur möglich, den Bauteilträger mit den LED etwas weiter entfernt von den Abstrahlflächen anzuordnen, sondern auch mit anderer Ausrichtung. Dies ist insbesondere für eine nachfolgend noch näher erläuterte Integration der Bedieneinrichtung samt Bauteilträger in eine Tür eines Geschirrspülers oder eine ähnliche Einbausituation von großem Vorteil. Es ist vorteilhaft möglich, die Sensorelementkörper in das zweite Gehäuseteil nicht nur lose einzusetzen oder unter Vorspannung oder Druck, sondern sie sozusagen bei der Herstellung zu integrieren. Hierfür bietet sich insbesondere ein eingangs genanntes Mehrkomponenten-Spritzgussverfahren an. Insbesondere ist bei einem vorteilhaften Aspekt für die erfindungsgemäße Bedieneinrichtung ein zweites Gehäuseteil als Lichtleiterbauteil vorgesehen, welches neben den Lichtleiterabschnitten bzw. Lichtleitermitteln auch die Sensorelementkörper integriert aufweist. Insbesondere müssen dann nämlich keine losen Sensorelementkörper in das zweite Gehäuseteil eingesetzt werden.

Auf dem Bauteilträger können Kontakte für die Sensorelementkörper angeordnet sein, beispielsweise Kontaktfelder nach Art von elektrisch leitfähigen Flächen auf dem Bauteilträger. Ist der Bauteilträger in das Gehäuse oder zumindest in das zweite Gehäuseteil eingeführt, so liegen die Sensorelementkörper direkt an dem Bauteilträger und an den Kontakten an. Dadurch kann vorteilhaft ein separater Kontaktierungsschritt entfallen.

In weiterer Ausgestaltung der Erfindung kann einer Anzahl der Sensorelementkörper, vorteilhaft mindestens der Hälfte, je ein Lichtleitermittel direkt zugeordnet sein. So kann an der Bedieneinrichtung nahe an einem Berührungsschalter eine Leuchtanzeige geschaffen werden. Vorteilhaft steht dabei eine Sensorelementfläche des Sensorelementkörpers, insbesondere als Endfläche, aus dem Gehäuse bzw. dem zweiten Gehäuseteil heraus. Das zugeordnete Lichtleitermittel weist eine vorgenannte Abstrahlfläche auf, die nahe an dieser Sensorelementfläche angeordnet ist, vorzugsweise mit einem Abstand von weniger als 1 cm dazu. Beide Flächen können parallel zueinander sein zur Anlage an einer Bedienblende.

Besonders vorteilhaft ist es möglich, den Sensorelementkörper zwischen der Abstrahlfläche einerseits und dem Bauteilträger andererseits anzuordnen. Dadurch ist eine vorbeschriebene elektrische Kontaktierung leicht möglich. Des Weiteren kann so eine hohe Integration und kleine gesamte Baugröße erreicht werden.

In vorteilhafter weiterer Ausgestaltung der Erfindung kann im zweiten Gehäuseteil eine Aufnahmeöffnung bzw. eine Aufnahme für einen Rand oder eine Kante des Bauteilträgers vorgesehen sein. Diese Aufnahmeöffnung weist dabei zu dem ersten Gehäuseteil hin. An der Aufnahme bzw. Aufnahmeöffnung ist eine Einführschräge vorgesehen, durch die die Aufnahmeöffnung in Richtung zum ersten Gehäuseteil hin derart erweitert ist, dass bei gegenüberliegend angeordnetem Sensorelementkörper der eingeschobene Bauteilträger zwischen Sensorelementkörper und Einführschräge einläuft. So ist es möglich, dass der Bauteilträger mit zunehmendem Einschieben stärker gegen die Sensorelementkörper gedrückt wird zur Herstellung der zuvor beschriebenen elektrischen Kontaktierung über Kontakte bzw. Kontaktfelder.

In weiterer Ausgestaltung der Erfindung kann vorgesehen sein, dass die Aufnahmeöffnung sowohl mit der Einführschräge als auch mit einer Gegenfläche von dem Lichtleiterbauteil bzw. dem zweiten Gehäuseteil gebildet wird. Bei einer besonders einfachen Ausgestaltung kann vorgesehen sein, dass an dem zweiten Gehäuseteil im Wesentlichen nur die vorgenannte Einführschräge vorgesehen ist. Dieser Einführschräge gegenüberliegend sind dann nur die Sensorelementkörper vorgesehen und keine sozusagen festen Teile des zweiten Gehäuseteils. Sind es jedoch genügend Sensorelementkörper mit einer ausreichenden Verteilung über die Erstreckung des Bauteilträgers, so wird dies als ausreichend angesehen. Vor allem kann dadurch auch eine einerseits klemmende und andererseits etwas elastische Befestigung erreicht werden.

Ein erfindungsgemäßes Elektrogerät weist eine bereichsweise lichtdurchlässige Bedienblende sowie eine vorgenannte Bedieneinrichtung auf. Dabei weist die Bedienblende lichtdurchlässige Bereiche auf sowie Berührbereiche. Die lichtdurchlässigen Bereiche dienen als Anzeige, die Berührbereiche sind für die Berührungsschalter als Bedienelemente vorgesehen. Die Bedieneinrichtung ist von hinten an die Bedienblende angedrückt, so dass die Lichtleitermittel hinter den lichtdurchlässigen Bereichen liegen, insbesondere mit den vorgenannten Abstrahlflächen. Die Sensorelementkörper liegen mit den vorgenannten Sensorelementflächen hinter den Berührbereichen an, wobei sie vorteilhaft an diese angedrückt sind. Die Bedienblende ist dabei entsprechend geeignet ausgebildet und kann lichtdurchlässige Einsätze aufweisen und ansonsten aus normalem Kunststoff bestehen.

In vorteilhafter Ausgestaltung der Erfindung ist das genannte Elektrogerät ein Geschirrspüler. Die Bedieneinrichtung kann besonders vorteilhaft in eine Tür des Geschirrspülers integriert sein derart, dass die genannte Bedienblende im oberen Türfalz angeordnet ist und somit bei geschlossener Tür unsichtbar ist. Die Bedieneinrichtung selbst ist innerhalb der Tür angeordnet. Eine Erstreckungsrichtung des Bauteilträgers kann parallel zur Tür verlaufen, so dass die Bedieneinrichtung relativ flach ist, um in der Tür untergebracht zu werden.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränkt die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine Schrägansicht einer erfindungsgemäßen Bedieneinrichtung mit zwei Gehäuseteilen und Bauteilträger dazwischen im auseinander gezogenen Zustand
- Fig. 2: einen Querschnitt durch die zusammengebaute Bedieneinrichtung entsprechend Fig. 1,
- Fig. 3: eine Seitenansicht eines Geschirrspülers mit geöffneter Tür und
- Fig. 4: eine Schnittdarstellung der Tür in starker Vergrößerung mit integrierter Bedieneinrichtung.

### Detaillierte Beschreibung der Ausführungsbeispiele

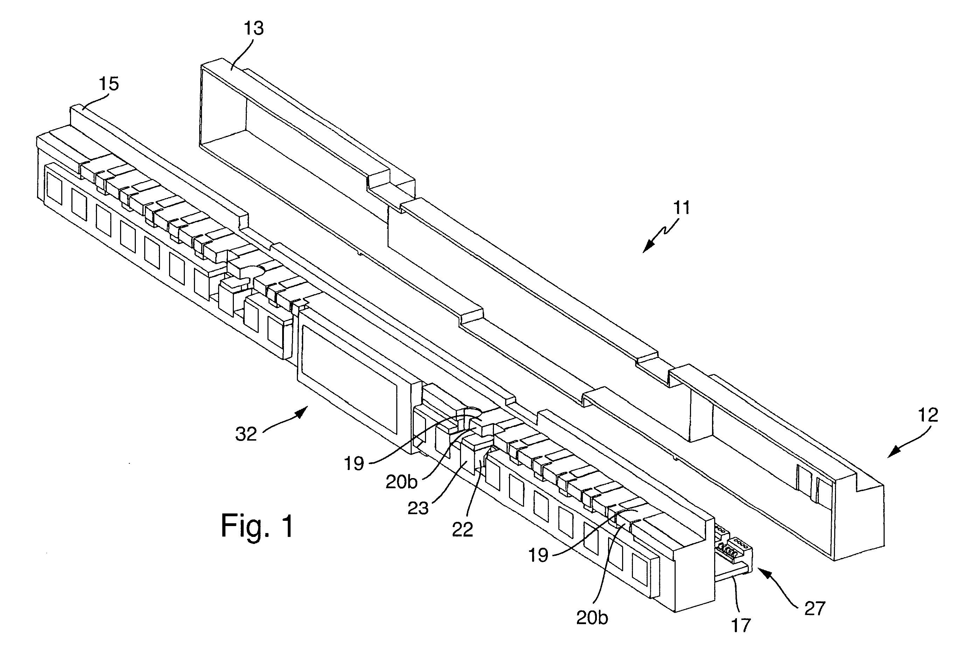

In Fig. 1 ist eine Bedieneinrichtung 11 im auseinander gezogenen Zustand dargestellt. Sie weist ein erstes Gehäuseteil 13 und ein zweites Gehäuseteil 15 auf, die erkennbar als Halbschalen ausgebildet sind und aus zuvor beschriebenen Kunststoffen bestehen können. Dazwischen befindet sich ein Bauteilträger 17, vorteilhaft in Form einer Leiterplatte.

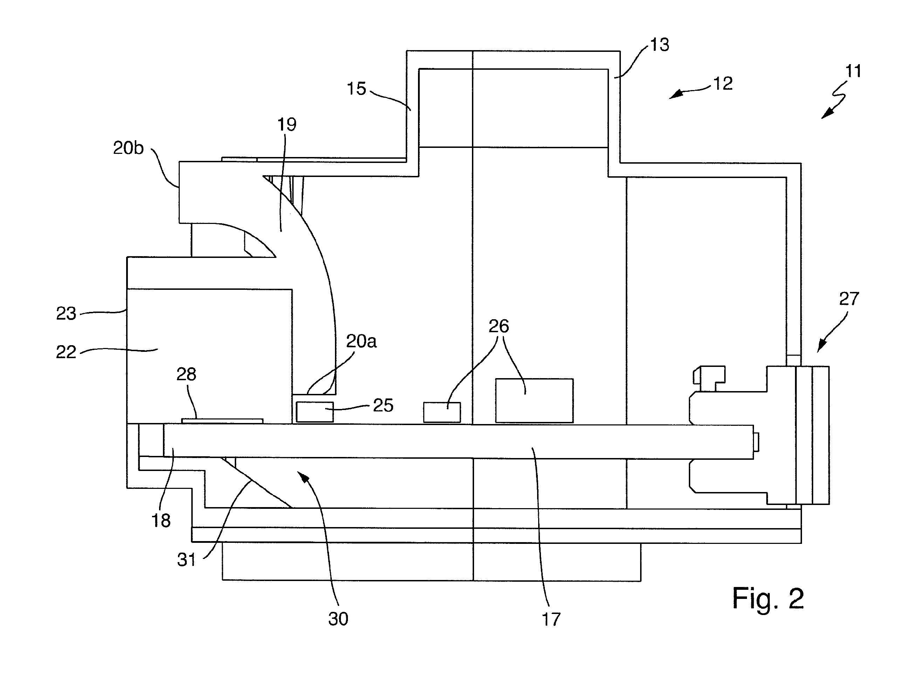

Das zweite Gehäuseteil ist dabei entsprechend dem ersten Aspekt der Erfindung ausgebildet. Insbesondere im Zusammenhang mit der Schnittdarstellung aus Fig. 2 im Querschnitt ist zu erkennen, dass im zweiten Gehäuseteil die vorgenannten Lichtleitermittel 19 als Lichtleiterabschnitte ausgebildet sind, und zwar in großer Anzahl. Sie weisen am unteren Ende Einstrahlflächen 20a und am linken oberen, nach links weisenden Ende sind Abstrahlflächen 20b vorgesehen. Wie aus Fig. 1 zu erkennen ist, sind die Lichtleitermittel 19 zumindest kurz vor den Abstrahlflächen 20b nach Art von Vorsprüngen ausgebildet bzw. durch Einschnitte von benachbarten Vorsprüngen getrennt, so dass ein Überleuchten reduziert oder vermieden wird. Ähnlich ist die Ausbildung auch an den unteren Enden zu den Einstrahlflächen 20a hin. Aus Fig. 2 ist zu erkennen, dass die Lichtleitermittel 19 gebogen sind und dabei in etwa einen Viertelkreis beschreiben bzw. die Einstrahlflächen 20a in einem rechten Winkel zu den Abstrahlflächen 20b stehen.

Des Weiteren sind in das zweite Gehäuseteil 15 Sensorelementkörper 22 integriert, und zwar durch das vorgenannte Mehrkomponenten-Spritzgußverfahren zusammen damit hergestellt. Die Sensorelementkörper 22 sind im Wesentlichen blockartig bzw. quaderförmig und weisen nach links eine Sensorelementfläche 23 auf, die rechteckig ist. In der hier gezeigten Ausführung sind die Sensorelementflächen 23 bündig mit den sie umgebenden Bereichen des zweiten Gehäuseteils 15, sie können aber auch etwas bzw. einige Millimeter darüber überstehen für eine bessere Anlage an der Rückseite einer Bedienblende, wie nachfolgend noch näher erläutert wird. In Fig. 1 ist zu erkennen, dass der achte Sensorelementkörper 22 von rechts teilweise frei liegt, was aus Montagegründen des gesamten Gehäuses 12 sein kann. Durch das Mehrkomponenten-Spritzgußverfahren ist er dennoch mechanisch sicher und unverlierbar im zweiten Gehäuseteil 15 integriert.

Der Bauteilträger 17 weist zumindest LED 25 als Leuchtmittel dicht unterhalb der Einstrahlflächen 20a der Lichtleitermittel 19 auf. Des Weiteren kann er zusätzliche Schaltungsbauteile 26 aufweisen, beispielsweise für sonstige Steuerfunktionen des Elektrogeräts. Am nach rechts weisenden Rand sind Kontakteinrichtungen 27 angeordnet, die durch entsprechende Öffnungen im ersten Gehäuseteil 13 nach hinten herausstehen für eine elektrische Kontaktierung. Schließlich sind unterhalb des Sensorelementkörpers 22 noch übertrieben dick dargestellte Kontaktfelder 28 vorgesehen, die an die Unterseite der Sensorelementkörper 22 angedrückt sind und diese so elektrisch kontaktieren.

Es ist zu erkennen, dass der linke Rand 18 des Bauteilträgers 17 in eine Art Aufnahmeöffnung 30 eingesteckt ist, welche unten eine Einführschräge 31 aufweist. Da die Aufnahmeöffnung 30 nach oben durch die elastischen Sensorelementkörper 22 gebildet wird ist klar, dass der Bauteilträger 17 beim Hineinstecken mit Einsteckrichtung von rechts nach links mit seinem linken Rand 18 an der Einführschräge 31 entlang läuft und dann an deren linkem Ende angekommen an der Unterseite des Sensorelementkörpers 22 anliegt, unter Umständen mit einer gewissen vorgebbaren Druckspannung. Dadurch wird der Bauteilträger 17 zum Einen fest gehalten und zum Anderen erfolgt eben die sichere elektrische Kontaktierung an den Sensorelementkörper 22 über die Kontaktfelder 28. Der rechte Bereich des Bauteilträgers 17 kann auf andere Art und Weise gehalten werden, unter Umständen mittels der Kontaktiereinrichtungen 27 oder eventuell auch gar nicht, sondern nur mit seinem linken Rand 18.

Aus den Fig. 1 und 2 ist zu erkennen, dass das aus den Gehäuseteilen 13 und 15 gebildete Gehäuse 12 geschlossen ist und somit der Bauteilträger 17 samt seinen Bauteilen im Wesentlichen staubdicht und auch wasserdicht darin gelagert sein kann. Aufgrund der Ausgestaltung der Lichtleitermittel 19 kann auch das im Wesentlichen gesamte Licht der LED 25 von den Lichtleitermitteln aufgenommen und an den Abstrahlflächen 20b wie gewünscht abgestrahlt werden, so dass unerwünschte Leuchterscheinungen vermieden werden können. Des Weiteren hängt dies auch stark mit der Einbausituation und der Bedieneinrichtung 11 zusammen. Des Weiteren kann, wie in Fig. 1 angedeutet ist, in der Mitte des zweiten Gehäuseteils 15 eine großflächige LCD-Anzeige 32 vorgesehen sein. Diese ist jedoch als separates Bauteil nicht in das zweite Gehäuseteil bei der Herstellung eingespritzt oder integriert, sondern wird von vorne anmontiert und dann an den Bauteilträger 17 angeschlossen.

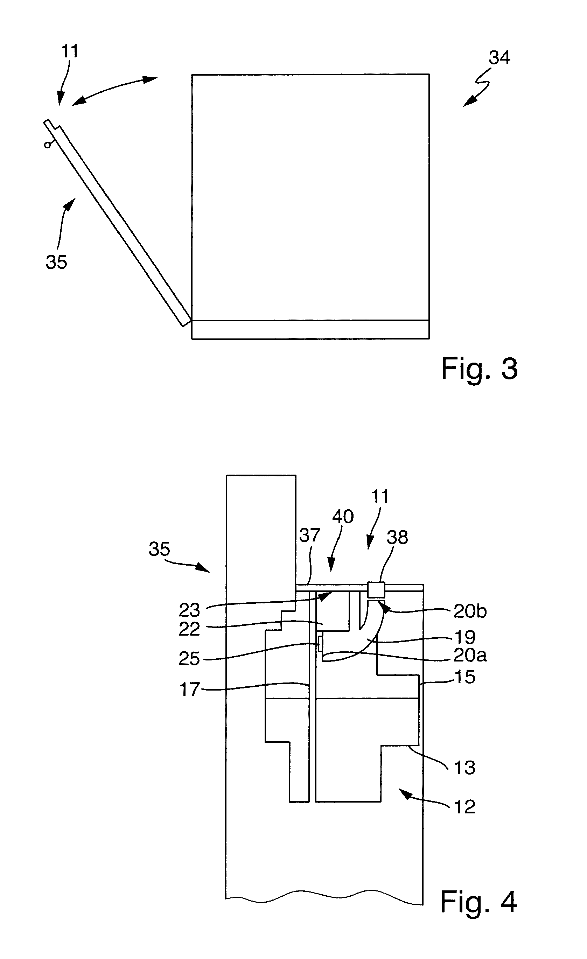

In Fig. 3 ist ein erfindungsgemäßes Elektrogerät als Geschirrspüler 34 dargestellt mit einer Tür 35. In diese Tür ist oben in den Türfalz die Bedieneinrichtung 11 integriert, wie aus der Vergrößerung im Schnitt der Fig. 4 hervorgeht. In diesem Türfalz der Tür 35 ist eine Bedienblende 37 vorgesehen, vorteilhaft aus Kunststoff. Sie kann an ihrer Oberseite mit Beschriftung sowie Symbolen versehen sein und aus lichtundurchlässigem Kunststoff bestehen. In entsprechenden Öffnungen sind Lichtfenster 38 eingesetzt. Alternativ können bei einer Herstellung der Bedienblende 37 aus durchsichtigem Kunststoff entsprechende Öffnungen oder Fenster von einer bedeckenden Maskierung oder Lackierung freigelassen werden. Hinter den Lichtfenstern 38 befinden sich die Abstrahlflächen 20b der Lichtleitermittel 19 der Bedieneinrichtung 11. So werden Leuchtanzeigen gebildet, wobei durch Gestaltung der Lichtfenster 38 verschiedene Formen möglich sind. Die LCD-Anzeige 32 aus Fig. 1 kann ein entsprechend großes Lichtfenster 38 aufweisen oder in eine entsprechende Öffnung in der Bedienblende 37 selber hineinpassen.

Des Weiteren sind Berührflächen 40 an der Bedienblende 37 vorgesehen und durch entsprechende Markierung für eine Bedienperson angezeigt, die den Sensorelementflächen 23 der Sensorelementkörper 22 entsprechen. An diesen Berührflächen 40 werden dann die vorgenannten Berührungsschalter als Bedienelemente gebildet. Legt eine Bedienperson hier ihren Finger auf, kann dies auf dem Fachmann bekannte Art und Weise als Betätigung ausgewertet werden.

Somit wird es mit der Erfindung möglich, eine Bedieneinrichtung 11 sehr leicht und modular aufzubauen. Ein Montagevorgang ist sehr einfach, da sozusagen das erste Gehäuseteil 13 und das zweite Gehäuseteil 15 jeweils im Wesentlichen fertig hergestellt werden können und weder Lichtleitermittel noch Sensorelementkörper separat in einem Montagevorgang befestigt werden müssen. Mögliche Montagefehler, Verschiebungen oder ein Vergessen von Teilen können nicht auftreten. Auch eine elektrische Kontaktierung der Sensorelementkörper 22 ist mit den Kontaktfeldern 28 am Bauteilträger 17 und dessen Einschieben in die Aufnahmeöffnung 30 sehr leicht und sicher durchzuführen. Die Form der Abstrahlflächen 20b der Lichtleitermittel 19 ermöglicht es auch, die Lichtfenster 38 der Bedienblende 37 durchaus anders auszubilden, also beispielsweise kreisförmig oder in Symbolform oder mehrteilig. Des Weiteren kann das zweite Gehäuseteil 15 auch genauso für solche Anwendungen bzw. Bedieneinrichtungen verwendet werden, bei denen weniger Sensorelementflächen 23 bzw. Abstrahlflächen 20b benötigt werden, da dann ganz einfach die Kontaktfelder 28 oder die LED 25 weggelassen werden.

## Patentansprüche

1. Gehäuseteil für eine Bedieneinrichtung, wobei das Gehäuseteil mehrere Abschnitte aufweist, vorzugsweise mit gleicher Erstreckungsrichtung, und zusammenhängend ausgebildet ist, wobei an dem Gehäuseteil eine Vielzahl von elektrisch leitfähigen und elastischen Sensorelementkörpern angeordnet ist, **dadurch gekennzeichnet, dass** die Sensorelementkörper zusammen mit dem Gehäuseteil hergestellt sind, insbesondere in einem Mehrkomponenten-Spritzgussverfahren.

2. Gehäuseteil nach Anspruch 1, **dadurch gekennzeichnet, dass** die Abschnitte als Lichtleiterabschnitte selbst aus Polycarbonat, Polymethylmethacrylat oder ABS bestehen.

3. Bedieneinrichtung für ein Elektrogerät mit:
- Bedienelementen als kapazitive Berührungssensoren,
- einem Bauteilträger mit Schaltungsbauteilen und Leuchtmitteln,
- einem Gehäuse für den Bauteilträger,
- Lichtleitermitteln für die Leuchtmittel und
- Sensorelementkörpern für kapazitive Sensorelemente für die Bedienelemente,
- wobei das Gehäuse den Bauteilträger zumindest teilweise
umschließt,
**dadurch gekennzeichnet, dass**
das Gehäuse zwei Gehäuseteile aufweist, wobei ein erstes Gehäuseteil aus lichtundurchlässigem Material besteht und ein zweites Gehäuseteil zumindest teilweise lichtleitend ist, wobei die Lichtleitermittel in das zweite Gehäuseteil integriert sind und wobei auch die Sensorelementkörper in dem zweiten Gehäuseteil angeordnet sind.

4. Bedieneinrichtung nach Anspruch 3, **dadurch gekennzeichnet, dass** das Gehäuse den Bauteilträger im Wesentlichen vollständig, insbesondere lichtundurchlässig und/oder staubundurchlässig, umgibt, wobei vorzugsweise beide Gehäuseteile schalenartig ausgebildet sind.

5. Bedieneinrichtung nach Anspruch 3 oder 4, **dadurch gekennzeichnet, dass** das gesamte zweite Gehäuseteil aus lichtleitendem und lichtdurchlässigem Kunststoff besteht und die Lichtleitermittel integral daran ausgebildet sind als zumindest teilweise in mindestens eine Richtung abstehende und voneinander durch einen Luftspalt getrennte Vorsprünge, wobei insbesondere diese Vorsprünge mindestens zu den Leuchtmitteln auf dem Bauteilträger hin weisen, vorzugsweise auch am anderen Ende der Lichtleitermittel in eine andere Richtung.

6. Bedieneinrichtung nach einem der Ansprüche 3 bis 5, **dadurch gekennzeichnet, dass** die Lichtleitermittel gebogen sind, wobei insbesondere eine Biegung mindestens einen Viertelkreis beschreibt.

7. Bedieneinrichtung nach einem der Ansprüche 3 bis 6, **dadurch gekennzeichnet, dass** die Sensorelementkörper in das zweite Gehäuseteil bei der Herstellung integriert sind, insbesondere durch ein Mehrkomponenten-Spritzgussverfahren eingespritzt sind.

8. Bedieneinrichtung nach einem der Ansprüche 3 bis 7, **dadurch gekennzeichnet, dass** auf dem Bauteilträger Kontakte für die Sensorelementkörper angeordnet sind und die Sensorelementkörper direkt an dem in das zweite Gehäuseteil eingeführten Bauteilträger und an den Kontakten anliegen.

9. Bedieneinrichtung nach einem der Ansprüche 3 bis 8, **dadurch gekennzeichnet, dass** mindestens der Hälfte der Sensorelementkörper je ein Lichtleitermittel direkt zugeordnet ist, wobei vorzugsweise eine Sensorelementfläche des Sensorelementkörpers aus dem Gehäuse heraussteht und eine zur Lichtabstrahlung vorgesehene Abstrahlfläche der Lichtleitermittel nahe an dieser Sensorelementfläche und parallel dazu vorgesehen ist, wobei vorzugsweise der Sensorelementkörper zwischen Abstrahlfläche und Bauteilträger angeordnet ist.

10. Bedieneinrichtung nach einem der Ansprüche 3 bis 9, **dadurch gekennzeichnet, dass** im zweiten Gehäuseteil eine Aufnahmeöffnung für einen Rand und/oder eine Kante des Bauteilträgers vorgesehen ist, wobei diese Aufnahmeöffnung zu dem ersten Gehäuseteil hin weist, wobei die Aufnahmeöffnung eine Einführschräge aufweist zur Erweiterung der Aufnahmeöffnung in Richtung des ersten Gehäuseteils derart, dass die Sensorelementkörper gegenüberliegend von der Einführschräge angeordnet sind und sich der eingeschobene Bauteilträger zwischen Sensorelementkörper und Einführschräge befindet.

11. Bedieneinrichtung nach einem der Ansprüche 3 bis 10, **dadurch gekennzeichnet, dass** das zweite Gehäuseteil nach Anspruch 1 oder 2 ausgebildet ist.

12. Elektrogerät mit einer bereichsweise lichtdurchlässigen Bedienblende und mit einer Bedieneinrichtung nach einem der Ansprüche 3 bis 11, **dadurch gekennzeichnet, dass** die Bedienblende lichtdurchlässige Bereiche und Berührbereiche aufweist, wobei die Bedieneinrichtung an die Bedienblende von hinten angedrückt ist mit den Lichtleitermitteln hinter den lichtdurchlässigen Bereichen und mit den Sensorelementkörpern hinter den Berührbereichen.

13. Elektrogerät nach Anspruch 12, **dadurch gekennzeichnet, dass** das Elektrogerät ein Geschirrspüler ist, wobei insbesondere die Bedieneinrichtung in eine Tür des Geschirrspülers integriert ist derart, dass die Bedienblende im oberen Türfalz angeordnet ist und die Bedieneinrichtung innerhalb der Tür angeordnet ist, vorzugsweise mit Erstreckungsrichtung des Bauteilträgers parallel zur Tür.
